# EUROPEAN PATENT APPLICATION

(11) **EP 3 301 733 A1**
(43) Date of publication of application: **04.04.2018**
(21) Application number: 15843075.1
(22) Date of filing: 17.11.2015
(51) Int. Cl.: H01L 51/52, H01L 51/50

(54) **ORGANIC LIGHT EMITTING DIODE SUBSTRATE AND ORGANIC LIGHT EMITTING DIODE DEVICE**

(30) Priority: 20.05.2015 CN 201510259540
(71) Applicant: BOE Technology Group Co., Ltd., Beijing 100015 (CN)
(72) Inventor: YANG, Yifan, Beijing 100176 (CN); ZHANG, Can, Beijing 100176 (CN); KONG, Chao, Beijing 100176 (CN)
(74) Representative: Lavoix
(86) International application number: PCT/CN2015/094765
(87) International publication number: WO 2016/184059

(57) **Abstract**

Provided are an Organic Light Emitting Diode (OLED) substrate and an OLED device. The OLED substrate includes: a transparent substrate, and a light emitting unit and a photoelectric conversion unit provided on the transparent substrate. The transparent substrate has an upper surface, a lower surface opposite to the upper surface, and a lateral surface. The light emitting unit is provided on the upper surface of the transparent substrate. The photoelectric conversion unit is provided on the lateral surface of the transparent substrate for absorbing light transmitted through the lateral surface of the transparent substrate and converting the absorbed light into electric energy through photoelectric conversion.

## Description

### CROSS-REFERENCE TO RELATED APPLICATION

The present application claims priority to Chinese patent application No. 201510259540.6 filed on May 20, 2015, which is incorporated herein by reference in its entirety.

### TECHNICAL FIELD

The present disclosure relates to the technical field of Organic Light Emitting Diode (OLED), and in particular to an OLED substrate and an OLED device.

### BACKGROUND

A display screen of excellent display effect can be manufactured using OLED technology, which has been widely applied to devices such as mobile phones, televisions and wearable devices. Further, illumination sources of good performance may be manufactured using this technology due to area light emitting characteristic of the OLED.

An OLED device mainly includes: a base substrate, a cathode, an anode, an organic functional layer and a light emitting layer both located between the cathode and the anode, a package cover plate and the like. When a direct-current bias is applied between the cathode and the anode, electrons from the cathode and holes from the anode are injected into the organic functional layer, and are recombined in the light emitting layer to emit light. Since films in the OLED structure have different optical parameters and a material forming each film may have a certain light absorbing ability, not all the light from the light emitting layer can be emitted out of the device to become effective light. In actual, the effective light makes up less than 25% of the whole light from the light emitting layer, and more than 75% light cannot be emitted out of the OLED device and is not utilized; therefore, the OLED device has low light utilization and high energy consumption.

How to improve the light utilization of the OLED is a technical program to be solved by those skilled in the art.

### SUMMARY

In view of this, the present disclosure provides an OLED substrate and an OLED device, such that the light utilization of the OLED device is effectively improved.

The present disclosure provides an OLED substrate, which includes: a transparent substrate and a light emitting unit provided on the transparent substrate. The transparent substrate has an upper surface, a lower surface opposite to the upper surface, and a lateral surface. The light emitting unit is provided on the upper surface of the transparent substrate. The OLED substrate may further include a photoelectric conversion unit, which is provided on the lateral surface of the transparent substrate for absorbing light transmitted through the lateral surface of the transparent substrate and converting the absorbed light into electric energy through photoelectric conversion.

Optionally, the photoelectric conversion unit may be film-like, and is attached onto the lateral surface of the transparent substrate.

Optionally, a number of the light emitting unit provided on the transparent substrate is one.

Optionally, a number of the light emitting units provided on the transparent substrate is multiple, each of the multiple light emitting units corresponds to one or more photoelectric conversion units located near the each of the multiple light emitting units, and the photoelectric conversion units corresponding to the multiple light emitting units are provided uniformly on the lateral surfaces of the transparent substrate.

Optionally, the photoelectric conversion unit may be a photovoltaic cell, and a width of the photovoltaic cell in a direction from the upper surface to the lower surface of the transparent substrate is equal to or less than a thickness of the transparent substrate.

Optionally, the transparent substrate may be a rectangular solid having four lateral surfaces, a number of the photoelectric conversion units is multiple, and the multiple photoelectric conversion units are provided uniformly on the four lateral surfaces of the transparent substrate.

Optionally, the transparent substrate may be a cylinder.

The present further provides an OLED device, which includes the above OLED substrate.

Optionally, a number of the light emitting unit provided on the transparent substrate is one, and the OLED device may further include: a control unit which is connected to the photoelectric conversion unit and the light emitting unit. The control unit is used to provide a driving voltage for the light emitting unit, detect a quantity of electric energy outputted from the photoelectric conversion unit, and adjust the driving voltage provided to the light emitting unit based on a detection result, such that the light emitting unit is maintained at a predetermined brightness.

Optionally, a number of the light emitting units provided on the transparent substrate is multiple, each of the multiple light emitting units corresponds to one or more photoelectric conversion units located near the each of the multiple light emitting units, and the photoelectric conversion units corresponding to the multiple light emitting units are provided uniformly on the lateral surfaces of the transparent substrate. The OLED device further includes:
a control unit connected to the photoelectric conversion units and the light emitting units. The control unit is used to provide a driving voltage to each of the multiple light emitting units, detect a quantity of electric energy outputted from the one or more photoelectric conversion units corresponding to the each of the multiple light emitting units, and adjust the driving voltages provided to the light emitting units based on a detection result, such that the multiple light emitting units have a same brightness.

Optionally, the OLED device may include: multiple OLED substrates above; and
a control unit, which is connected to the photoelectric conversion unit and the light emitting units of each of the multiple OLED substrates and is used to provide a driving voltage to the light emitting unit of each of the multiple OLED substrates, detect a quantity of electric energy outputted from the photoelectric conversion unit of each of the multiple OLED substrates, and adjust the driving voltages provided to the light emitting units of the multiple OLED substrates based on a detection result such that the multiple OLED substrates have a same brightness.

Optionally, the OLED device may further include an electric energy storage unit, which is used to store electric energy generated by the photoelectric conversion unit.

Optionally, the electricity storage unit is connected to the control unit, the control unit may operate in a first power supplying mode or a second power supplying mode. In the first power supplying mode, the control unit may convert an external alternating current into a direct current, generate a first driving voltage based on the direct current and provide the first driving voltage to the light emitting unit. In the second power supplying mode, the control unit may generate a second driving voltage using the electric energy stored in the electric energy storage unit, and provide the second driving voltage to the light emitting unit.

Optionally, in the OLED device, the photoelectric conversion unit of the OLED substrate may be a photovoltaic cell, and a width of the photovoltaic cell in a direction from the upper surface to the lower surface of the transparent substrate is equal to or less than a thickness of the transparent substrate.

Optionally, in the OLED device, the transparent substrate of the OLED substrate may be a rectangular solid having four lateral surfaces, a number of the photoelectric conversion units is multiple, and the multiple photoelectric conversion units are provided uniformly on the four lateral surfaces of the transparent substrate.

Optionally, in the OLED device, the photoelectric conversion unit may be film-like and is attached onto the lateral surface of the transparent substrate.

In related technologies, light transmitted through a lateral surface of a transparent substrate in an OLED substrate is not fully utilized. In the present disclosure, a photoelectric conversion unit is provided on the lateral surface of the transparent substrate for absorbing light transmitted through the lateral surface of the transparent substrate and converting the absorbed light into electric energy through photoelectric conversion, thereby enhancing light utilization of the OLED device.

### BRIEF DESCRIPTION OF THE DRAWINGS

Figure 1 is a schematic structural diagram of an OLED substrate according to an embodiment of the present disclosure;
Figure 2 is a schematic structural diagram of an OLED substrate according to an embodiment of the present disclosure;
Figure 3 is a schematic structural diagram of an OLED device according to an embodiment of the present disclosure;
Figure 4 is a schematic structural diagram of an OLED device according to an embodiment of the present disclosure; and
Figure 5 is a schematic structural diagram of an OLED device according to an embodiment of the present disclosure.

### DETAILED DESCRIPTION

Research has shown that, in an OLED device based on the related technology, a large part of light is transmitted through lateral surfaces of a transparent substrate of the OLED device. In embodiments of the present disclosure, in order to utilize such large part of light, a photoelectric conversion unit is provided on the lateral surfaces of the transparent substrate for absorbing light transmitted through the lateral surfaces of the transparent substrate and converting the absorbed light into electric energy through photoelectric conversion, thereby improving the light utilization of the OLED device.

It is provided an OLED substrate according to an embodiment of the present disclosure, which includes: a transparent substrate, and a light emitting unit and a photoelectric conversion unit both provided on the transparent substrate. The transparent substrate has an upper surface, a lower surface opposite to the upper surface, and a lateral surface. The light emitting unit is provided on the upper surface of the transparent substrate, and the photoelectric conversion unit is provided on the lateral surface of the transparent substrate for absorbing light transmitted through the lateral surface of the transparent substrate and converting the absorbed light into electric energy through photoelectric conversion.

Optionally, the photoelectric conversion unit may be film-like, and is directly attached onto the lateral surfaces of the transparent substrate. The photoelectric conversion unit may be strip-shaped, and the size of the photoelectric conversion unit matches the size of the lateral surface where the photoelectric conversion unit is located.

Optionally, the photoelectric conversion unit may be a photovoltaic cell, in particular, may be a silicon cell (such as, a mono-crystalline-silicon cell, a poly-crystalline silicon cell or an amorphous silicon cell), a gallium arsenide cell, a copper-indium-selenium cell and an organic polymer cell. The photovoltaic cell can efficiently absorb the luminescence spectrometry of the OLED device on which is the photovoltaic cell is provided and has high photoelectric conversion efficiency. Optionally, the photovoltaic cell may be easily made into a narrow stripe; a width of the narrow strip in a direction from the upper surface to the lower surface of the transparent substrate is equal to or slightly less than a thickness of the transparent substrate which is approximately from 0.3mm to 5mm.

The transparent substrate may be a glass or plastic substrate, and of course, transparent substrates made of other materials are not excluded. Preferably, the transparent substrate is a glass substrate whose visible light transmittance is typically greater than 90% and whose thickness is between 0.2mm and 5mm.

The light emitting unit includes a cathode, an organic layer and an anode. The anode is transparent and conductive, whose visible light transmittance is typically greater than 80%. The anode may be made of a metal oxide, a metal or an organic polymer. Preferably, the anode is a transparent conductive film made of indium tin oxide (ITO). The organic layer includes an organic functional layer and an organic light emitting layer, and the organic functional layer includes a hole injection layer, a hole transparent layer, an electron transparent layer, an electron injection layer and the like. The organic light emitting layer may be made of a light emitting material such as a fluorescent or phosphorescent material. The organic functional layer and the organic light emitting layer may be produced in manners such as vapor deposition, spin coating and ink jet printing, preferably using vapor deposition. The cathode has a high reflectivity, and is typically made of a metal or an alloy of a relative low work function, such as magnesium, aluminium, or an alloy of magnesium and aluminium, or the like.

In the above embodiment, the OLED substrate may be a substrate of an OLED illumination device, or a substrate of an OLED display device.

Specific implementations of the present disclosure are further described in detail below in conjunction of accompanying drawings and the embodiments. The following embodiments are merely for illustrating the present disclosure, and are not intended to limit the scope of the present disclosure.

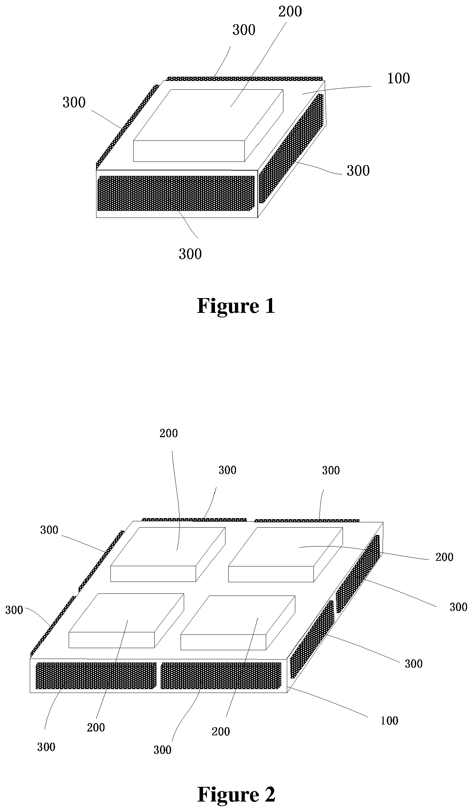

Reference is made to Figure 1, which illustrates a schematic structure of an OLED substrate according to an embodiment of the present disclosure. The OLED substrate includes a transparent substrate 100 and a light emitting unit 200 provided on the transparent substrate. The transparent substrate 100 has an upper surface, a lower surface opposite to the upper surface, and lateral surfaces. The light emitting unit 200 is provided on the upper surface of the transparent substrate 100. In order to improve the light utilization of an OLED device including this OLED substrate, the OLED substrate in the embodiment of the present disclosure may further include four photoelectric conversion units 300, which are provided on the lateral surfaces of the transparent substrate 100 for absorbing light transmitted through the lateral surfaces of the transparent substrate 100 and converting the absorbed light into electric energy through photoelectric conversion.

In the embodiment of the present disclosure, the transparent substrate 100 is a rectangular solid having four lateral surfaces, and each lateral surface is provided with one photoelectric conversion unit. Of course, the transparent substrate is not limited to a rectangular solid. In other embodiments of the present disclosure, the transparent substrate may be a cylinder, or in other shapes. Further, the number of the photoelectric conversion units is not limited to four.

Reference is made to Figure 2, which illustrates a schematic structure of an OLED substrate according to an embodiment of the present disclosure. The difference between the OLED substrate and the OLED substrate shown in Figure 1 is that: the transparent substrate 100 is provided with four light emitting units 200, while the transparent substrate 100 shown in Figure 1 is provided with only one light emitting unit 200. Further, in the embodiment shown in Figure 2, the OLED substrate includes eight photoelectric conversion units 300, and each light emitting element 200 corresponds to two photoelectric conversion units 300 which are located near the each light emitting element 200.

In the OLED substrate according to the above embodiments, since the photoelectric conversion units are provided on the lateral surfaces of the transparent substrate, light transmitted through the lateral surfaces of the transparent substrate is converted into electric energy and the electric energy can be utilized, thereby improving the light utilization of an OLED device including the OLED substrate.

It is further provided an OLED device according to an embodiment of the present disclosure, which includes an OLED substrate of any one embodiment described above. The OLED device may be an illumination device or a display device.

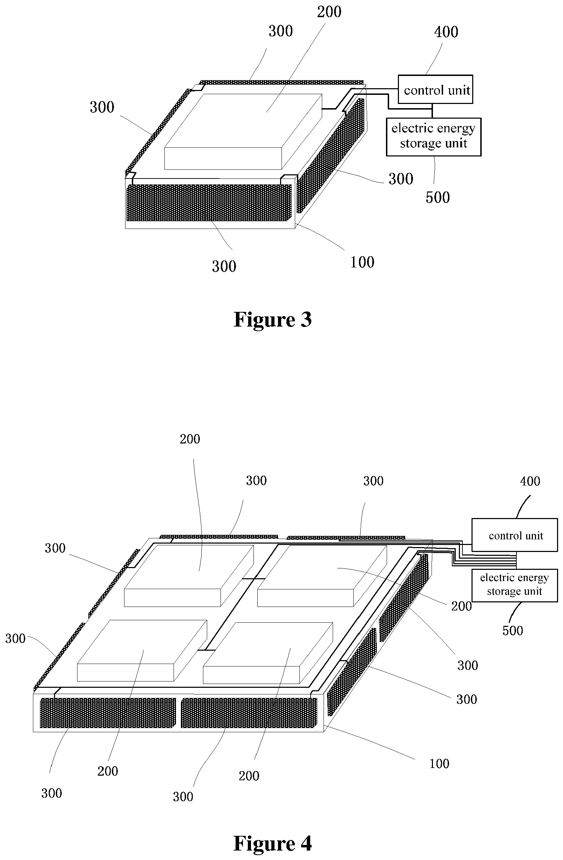

Reference is made to Figure 3, which illustrates a schematic structure of an OLED device according to an embodiment of the present disclosure. The OLED device includes an OLED substrate, the structure of which may be understood with reference to the embodiment shown in Figure 1. The OLED device further includes a control unit 400 and an electric energy storage unit 500.

The control unit 400 is connected to a light emitting unit 200 on the OLED substrate, and may convert an external alternating current into a direct current, generate a driving voltage based on the direct current and provide the driving voltage to the light emitting unit 200.

The electric energy storage unit 500 is connected to photoelectric conversion units 300 for storing electric energy generated by the photoelectric conversion units 300.

In the embodiment of the present disclosure, four photoelectric conversion units 300 are connected in series and are connected to the control unit 400 and the electric energy storage unit 500. Alternatively, in other embodiments of the present disclosure, four photoelectric conversion units 300 may be respectively connected to the control unit 400 and the electric energy storage unit 500.

Optionally, the upper surface of the transparent substrate 100 includes a light emitting region and a non-light-emitting region. The light emitting unit 200 is provided in the light emitting region. A connection wire for connecting the control unit 400 and the light emitting unit 200, a connection wire for connecting the photoelectric conversion units 300 and the control unit 400, and a connection wire for connecting the photoelectric conversion units 300 and the electric energy storage unit 500 are provided in the non-light-emitting region.

In the embodiment of the present disclosure, the electric energy stored in the electric energy storage unit 500 may be provided to the light emitting unit 200 on the OLED substrate, that is, the electric energy storage unit 500 can serve as an emergency power supply of the OLED device. In addition, the electric energy stored in the electric energy storage unit 500 may be provided to other electronic devices.

In a case that the electric energy storage unit 500 serves as an emergency power supply of the OLED device, the electric energy storage unit 500 is connected to the control unit 400. The control unit 400 may operate in a first power supplying mode and a second power supplying mode. In the first power supplying mode, the control unit 400 may convert an external alternating current into a direct current, generate a first driving voltage based on the direct current and provide the first driving voltage to the light emitting unit 200. In the second power supplying mode, the control unit 400 may generate a second driving voltage using the electric energy stored in the electric energy storage unit 500, and provide the second driving voltage to the light emitting unit 200.

Specifically, the first power supplying mode may be a normal utility power supplying mode, and the second power supplying mode may be a utility power outage mode. In this case, the control unit 400 is also capable of detecting whether the utility power is normally supplied or not, switching to the first power supplying mode to supply power when it is detected that the utility power is normally supplied and the control unit 400 operates in the second power supplying mode, and switching to the second power supplying mode to supply power when an outage of the utility power is detected and the control unit 400 operates in the first power supplying mode, such that the OLED device according to the embodiment of the present disclosure can also operate normally for some time even in case of outage of the utility power.

In the embodiment of the present disclosure, the light emitting unit 200 on the OLED substrate is aged during long-term use of the OLED device and the brightness of the OLED device is decreased, and correspondingly, the electric energy outputted by the photoelectric conversion units 300 provided on the transparent substrate 100 may be decreased. Therefore, in the embodiment of the present disclosure, the control unit 400 can detect quantity of electric energy outputted from the photoelectric conversion units 300 and adjust a driving voltage provided to the light emitting unit 200 based on the detection result such that the OLED device is maintained at a predetermined brightness. That is, the photoelectric conversion units 300 provided on the lateral surfaces of the transparent substrate 100 serve as sensors for brightness of light emitted by the OLED device, and the brightness of the light emitted by the OLED device are controlled in real-time based on a sensing signal. For example, when the control unit 400 detects that decreasing electric energy outputted from the photoelectric conversion units 300, the driving voltage supplied to the light emitting unit 200 can be increased appropriately, so as to ensure a best display or illumination effect.

Reference is made to Figure 4, which illustrates a schematic structure of an OLED device according to an embodiment of the present disclosure. The OLED device includes an OLED substrate, the structure of which may be understood with reference to the embodiment shown in Figure 2. The OLED device further includes a control unit 400 and an electric energy storage unit 500.

The control unit 400 is connected to light emitting units 200 on the OLED substrate, and may convert an external alternating current into a direct current, generate a driving voltage based on the direct current and provide the driving voltage to the light emitting units 200.

The electric energy storage unit 500 is connected to photoelectric conversion units 300 and is for storing electric energy generated by the photoelectric conversion units 300.

Optionally, the upper surface of the transparent substrate 100 includes a light emitting region and a non-light-emitting region. The light emitting units 200 are provided in the light emitting region. A connection wire for connecting the control unit 400 and the light emitting units 200, a connection wire for connecting the photoelectric conversion units 300 and the control unit 400, and a connection wire for connecting the photoelectric conversion units 300 and the electric energy storage unit 500 are provided in the non-light-emitting region.

In the embodiment of the present disclosure, the electric energy stored in the electric energy storage unit 500 may be provided to the light emitting units 200 on the OLED substrate, that is, the electric energy storage unit 500 can serve as an emergency power supply of the OLED device. In addition, the electric energy stored in the electric energy storage unit 500 may be provided to other electronic devices.

In a case that the electric energy storage unit 500 serves as an emergency power supply of the OLED device, the electric energy storage unit 500 is connected to the control unit 400. The control unit 400 may operate in a first power supplying mode and a second power supplying mode. In the first power supplying mode, the control unit 400 may convert an external alternating current into a direct current, generate a first driving voltage based on the direct current and provide the first driving voltage to the light emitting units 200. In the second power supplying mode, the control unit 400 may generate a second driving voltage using the electric energy stored in the electric energy storage unit 500, and provide the second driving voltage to the light emitting units 200.

Specifically, the first power supplying mode may be a normal utility power supplying mode, and the second power supplying mode may be a utility power outage mode. In this case, the control unit 400 is also capable of detecting whether the utility power is normally supplied or not, switching to the first power supplying mode to supply power when it is detected that the utility power is normally supplied and the control unit 400 operates in the second power supplying mode, and switching to the second power supplying mode to supply power when an outage of the utility power is detected and the control unit 400 operates in the first power supplying mode, such that the OLED device according to the embodiment of the present disclosure can also operate normally for some time even in case of outage of the utility power.

In the embodiment of the present disclosure, when one of the multiple light emitting units 200 of the OLED device is aged, the brightness of a region corresponding to the light emitting unit 200 is decreased, and the electric energy outputted by the photoelectric conversion units 300 corresponding to the light emitting unit 200, i.e., photoelectric conversion units 300 provided near the light emitting unit 200, may be decreased correspondingly. When lights emitted by different light emitting units 200 are not of an identical brightness, display or illumination effect of the OLED device may be greatly affected. In the embodiment of the present disclosure, the control unit 400 can detect quantity of electric energy outputted from the photoelectric conversion units 300 corresponding to each light emitting unit 200 and adjust the driving voltage provided to the each light emitting unit 200 based on the detection result, such that all the light emitting units 200 have a substantially same display brightness or illumination brightness, thereby ensuring best display or illumination effect.

In the embodiment of the present disclosure, the control unit 400 is connected to the photoelectric conversion units 300 corresponding to each light emitting unit 200, such that quantity of electric energy outputted from the photoelectric conversion units 300 corresponding to each light emitting unit 200 can be detected.

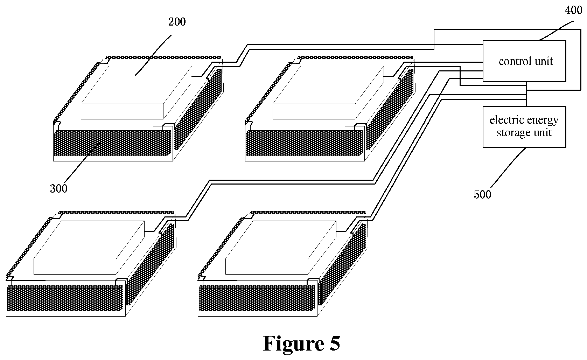

Reference is made to Figure 5, which illustrates a schematic structure of an OLED device according to an embodiment of the present disclosure. The OLED device includes four OLED substrates, the structure of each OLED substrate may be understood with reference to the embodiment shown in Figure 1. The OLED device further includes a control unit 400 and an electric energy storage unit 500.

The control unit 400 is connected to a light emitting unit 200 on each OLED substrate, and may convert an external alternating current into a direct current, generate a driving voltage based on the direct current and provide the driving voltage to the light emitting units 200.

The electric energy storage unit 500 is connected to photoelectric conversion units 300 on each OLED substrate and is for storing electric energy generated by the photoelectric conversion units 300.

Optionally, the upper surface of each transparent substrate 100 includes a light emitting region and a non-light-emitting region. The light emitting unit 200 is provided in the light emitting region. A connection wire for connecting the control unit 400 and the light emitting unit 200, a connection wire for connecting the photoelectric conversion units 300 and the control unit 400, and a connection wire for connecting the photoelectric conversion units 300 and the electric energy storage unit 500 are provided in the non-light-emitting region.

In the embodiment of the present disclosure, the electric energy stored in the electric energy storage unit 500 may be provided to the light emitting unit 200 on each OLED substrate, that is, the electric energy storage unit 500 can serve as an emergency power supply of the OLED device. In addition, the electric energy stored in the electric energy storage unit 500 may be provided to other electronic devices.

In a case that the electric energy storage unit 500 serves as an emergency power supply of the OLED device, the electric energy storage unit 500 is connected to the control unit 400. The control unit 400 may operate in a first power supplying mode and a second power supplying mode. In a first power supplying mode, the control unit 400 may convert an external alternating current into a direct current, generate a first driving voltage according to the direct current and provide the first driving voltage to the light emitting units 200. In the second power supplying mode, the control unit 400 may generate a second driving voltage using the electric energy stored in the electric energy storage unit 500, and provide the second driving voltage to the light emitting units 200.

Specifically, the first power supplying mode may be a normal utility power supplying mode, and the second power supplying mode may be a utility power outage mode. In this case, the control unit 400 is also capable of detecting whether the utility power is normally supplied or not, switching to the first power supplying mode to supply power when it is detected that the utility power is normally supplied and the control unit 400 operates in the second power supplying mode, and switching to the second power supplying mode to supply power when an outage of the utility power is detected and the control unit 400 operates in the first power supplying mode, such that the OLED device according to the embodiment of the present disclosure can also operate normally for some time even in case of outage of the utility power.

In the embodiment of the present disclosure, when one of the OLED substrates of the OLED device is aged, the brightness of a region corresponding to the OLED substrate is decreased, and the electric energy outputted by the photoelectric conversion units 300 on the OLED substrate may be decreased correspondingly. When lights emitted by different OLED substrates are not of an identical brightness, display or illumination effect of the OLED device may be greatly affected. In order to solve the problem, in the embodiment of the present disclosure, the control unit 400 can detect quantity of electric energy outputted from the photoelectric conversion units 300 of each OLED substrate and adjust the driving voltage provided to the light emitting units 200 on the respective OLED substrates based on the detection result, such that all the OLED substrates have a substantially same display brightness or illumination brightness ,thereby ensuring best display or illumination effect.

In each of the above embodiments, the electric energy storage unit 500 may be storage batteries such as a lithium battery, a nickel-hydrogen battery, a nickel cadmium battery or a lead-acid battery.

Those described above are only preferred embodiments of the present disclosure. It should be noted that, for the skilled in the art, improvements and modifications may also be made without departing from the principle of the present disclosure. Those improvements and modifications should also be included in the scope of protection of the present disclosure.

## Claims

1. An Organic Light Emitting Diode (OLED) substrate, comprising: a transparent substrate and a light emitting unit provided on the transparent substrate, wherein the transparent substrate includes an upper surface, a lower surface opposite to the upper surface, and a lateral surface, the light emitting unit is provided on the upper surface of the transparent substrate; wherein the OLED substrate further comprises a photoelectric conversion unit provided on the lateral surface of the transparent substrate for absorbing light transmitted through the lateral surface of the transparent substrate and converting the absorbed light into electric energy through photoelectric conversion.

2. The OLED substrate according to claim 1, wherein the photoelectric conversion unit is film-like and is attached onto the lateral surface of the transparent substrate.

3. The OLED substrate according to claim 1 or 2, wherein a number of the light emitting unit provided on the transparent substrate is one.

4. The OLED substrate according to claim 1 or 2, wherein a number of the light emitting units provided on the transparent substrate is plural, each of the plurality of light emitting units corresponds to one or more photoelectric conversion units located near the each of the plurality of light emitting units, and the photoelectric conversion units corresponding to the plurality of light emitting units are provided uniformly on the lateral surfaces of the transparent substrate.

5. The OLED substrate according to claim 1, wherein the photoelectric conversion unit is a photovoltaic cell, and a width of the photovoltaic cell in a direction from the upper surface to the lower surface of the transparent substrate is equal to or less than a thickness of the transparent substrate.

6. The OLED substrate according to claim 1, wherein the transparent substrate is a rectangular solid having four lateral surfaces, a number of the photoelectric conversion units is plural, and the plurality of photoelectric conversion units is provided uniformly on the four lateral surfaces of the transparent substrate.

7. The OLED substrate according to claim 1, wherein the transparent substrate is a cylinder.

8. An Organic Light Emitting Diode (OLED) device, comprising the OLED substrate of claim 1.

9. The OLED device according to claim 8, wherein a number of the light emitting unit provided on the transparent substrate is one, and the OLED device further comprises: a control unit which is connected to the photoelectric conversion unit and the light emitting unit and is configured to provide a driving voltage to the light emitting unit, detect a quantity of electric energy outputted from the photoelectric conversion unit and adjust the driving voltage provided to the light emitting unit based on a detection result such that the light emitting unit is maintained at a predetermined brightness.

10. The OLED device according to claim 8, wherein a number of the light emitting units provided on the transparent substrate is plural, each of the plurality of light emitting units corresponds to one or more photoelectric conversion units located near the each of the plurality of light emitting units, and the photoelectric conversion units corresponding to the plurality of light emitting units are provided uniformly on the lateral surfaces of the transparent substrate; wherein the OLED device further comprises:
a control unit, which is connected to the photoelectric conversion units and the light emitting units and is configured to provide a driving voltage to each of the plurality of light emitting units, detect a quantity of electric energy outputted from the one or more photoelectric conversion units corresponding to the each of the plurality of light emitting units, and adjust the driving voltages provided to the light emitting units based on a detection result such that the plurality of light emitting units has a same brightness.

11. The OLED device according to claim 8, comprising
a plurality of the OLED substrates; and
a control unit, which is connected to the photoelectric conversion unit and the light emitting unit of each of the plurality of OLED substrates and is configured to provide a driving voltage to the light emitting unit of each of the plurality of OLED substrates, detect a quantity of electric energy outputted from the photoelectric conversion unit of each of the plurality of OLED substrates, and adjust the driving voltages provided to the light emitting units of the plurality of OLED substrates based on a detection result such that the plurality of OLED substrates has a same brightness.

12. The OLED device according to any of claims 9 to 11, further comprising:
an electric energy storage unit, configured to store the electric energy generated by the photoelectric conversion unit.

13. The OLED device according to claim 12, wherein the electric energy storage unit is connected to the control unit, the control unit operates in a first power supplying mode or in a second power supplying mode;
in the first power supplying mode, the control unit converts an external alternating current into a direct current, generates a first driving voltage based on the direct current and provides the first driving voltage to the light emitting unit;
in the second power supplying mode, the control unit generates a second driving voltage using the electric energy stored in the electric energy storage unit, and provides the second driving voltage to the light emitting unit.

14. The OLED device according to claim 8, wherein the photoelectric conversion unit is a photovoltaic cell, and a width of the photovoltaic cell in a direction from the upper surface to the lower surface of the transparent substrate is equal to or less than a thickness of the transparent substrate.

15. The OLED device according to claim 8, wherein the transparent substrate is a rectangular solid having four lateral surfaces, a number of the photoelectric conversion units is plural, and the plurality of photoelectric conversion units is provided uniformly on the four lateral surfaces of the transparent substrate.

16. The OLED device according to claim 8, wherein the photoelectric conversion unit is film-like and is attached onto the lateral surface of the transparent substrate.
